# EUROPEAN PATENT SPECIFICATION

(11) **EP 4 318 951 B1**
(45) Date of publication and mention of the grant of the patent: **22.04.2026**
(21) Application number: 21936144.1
(22) Date of filing: 02.07.2021
(51) Int. Cl.: H03L 7/22, H03L 7/08

(54) **SYSTEM AND METHOD FOR IMPLEMENTING BROADBAND RF COMMUNICATION**
SYSTEM UND VERFAHREN ZUR IMPLEMENTIERUNG VON BREITBAND-HF-KOMMUNIKATION
SYSTÈME ET PROCÉDÉ DE MISE EN ?UVRE D'UNE COMMUNICATION RF À LARGE BANDE

(30) Priority: 09.04.2021 KR 20210046757
(43) Date of publication of application: 07.02.2024
(73) Proprietor: Point2 Technology, Inc., Seoul 06034 (KR)
(72) Inventor: BAE, Hyeon Min, Daejeon 34141 (KR); CHOI, Han Ho, Daejeon 34141 (KR)
(74) Representative: RGTH
(86) International application number: PCT/KR2021/008454
(87) International publication number: WO 2022/215806

(56) References cited:
- JP-A- 2013 051 569
- JP-A- H09 181 629
- JP-A- H09 181 629
- KR-B1- 100 852 611
- US-A- 5 046 124
- US-A- 6 122 326
- US-A1- 2001 048 715
- US-A1- 2004 196 920

## Description

### TECHNICAL FIELD

The present disclosure relates to a system and a method for implementing a broadband radio frequency (RF) communication.

### BACKGROUND

Data traffic that occurs in a data center, a connected car, an image processing device, and the like increases rapidly as a cloud service, a high-definition video service, and the like are widely distributed. This requires increasing a data transmission/reception speed of an input/output (I/O) bus that connects integrated circuits (ICs).

Over the past decades, a conductor-based interconnect (e.g., a copper wire, or the like) that is excellent in cost efficiency and power efficiency has been widely used in a wired communication system. However, the conductor-based interconnect has a fundamental limit on a channel bandwidth due to a skin effect caused by electromagnetic induction.

As an alternative to the conductor-based interconnect, an optical-based interconnect having a high data transmission/reception speed is introduced and widely used. However, such optical-based interconnect has a limitation that it is difficult to perfectly replace the conductor-based interconnect because the installation and maintenance costs are very large.

In recent years, a new type of interconnect configured with a waveguide made of a dielectric has been introduced. This new interconnect (namely, E-TUBE) is an interconnect having advantages of both a metal and a dielectric, which has a high efficiency in terms of cost and power and enables a high-speed data communication in a narrow range. Thus, the new interconnect gets in the spotlight as an interconnect that may be utilized for chip-to-chip communication.

On the other hand, the chip-to-chip communication using a dielectric waveguide as an interconnect almost corresponds to a wireless (RF) communication, and needs to implement a broadband coherent communication in the range of several tens of gigahertz (GHz) or more unlike the existing wireless communication. This requires to provide technical means for implementing a phase synchronization at a receiving end of such a broadband coherent communication system.

As an example of a technology for implementing the phase synchronization in the related art, there may be a technology utilizing an in-phase/quadrature-phase (I/Q) demodulation. According to such a technology in the related art, a system may be required to have a significantly complicated configuration for generating an I/Q phase and a high-speed analog-to-digital converter (ADC) having high power consumption may be required to accurately perform demodulation.

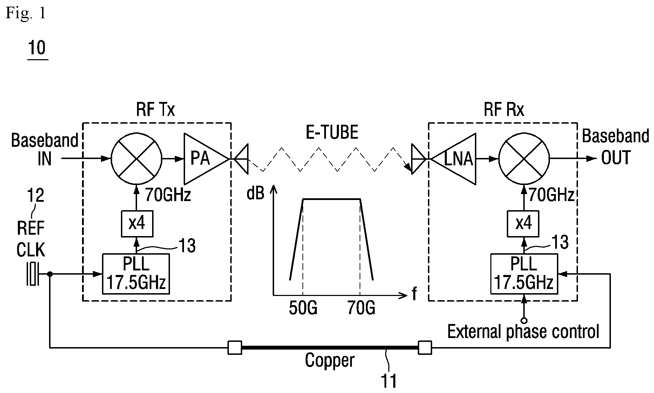

As another example of a technology in the related art, as illustrated in FIG. 1, there may be an RF communication system 10 that provides a forwarded clock for phase synchronization to a receiving end through a wired line (a copper wire or the like) 11 connecting a transmitting end and the receiving end. However, in such a technology in the related art, a very low frequency needs to be used to reduce transmission loss of a forwarded reference clock 12. This remarkably increases a ratio of the forwarded reference clock 12 (several hundreds of megahertz (MHz)) to a clock 13 (several tens of GHz) generated by a phase locked loop (PLL) (i.e., a PLL dividing ratio), which becomes sensitive to noise. This results in a high RF phase ambiguity. In addition, the technology in the related art has a technical limitation that the phase synchronization is performed depending on the forwarded clock alone, and thus a dynamic phase offset may not be tracked.

For example, JP H09-181629 A discloses a carrier-recovery demodulation architecture with frequency conversion and demodulation stages, a VCO, fixed/variable oscillators and dividers, a phase comparator and loop filter. The control loop adjusts the carrier frequency (fvco) with respect to symbol/data characteristics, i.e., a defined relationship between carrier and baseband parameters during recovery. Further, US 6 122 326 A relates to receiver carrier/clock recovery techniques employing PLL/VCO-based control with phase/frequency discrimination for demodulation. It illustrates conventional loop components (e.g., discriminators, oscillators, loop filters) used to stabilise the recovered carrier/clock in RF receivers. Moreover, US 5 046 124 A teaches carrier recovery and demodulation circuits using phase-sensitive detection and loop control (phase detector, loop filter, VCO/PLL) for coherent demodulation. It exemplifies standard single-loop approaches to align the local oscillator with the incoming signal's carrier for baseband extraction. However, none addresses, as such background art, a dual-PLL architecture in which a baseband-driven PLL provides the reference to an RF PLL after an initial lock-detect switchover, nor do they discuss setting a predetermined (e.g., integer-multiple) relationship between carrier frequency and baseband data rate to mitigate negative-frequency side-lobe effects and related deterministic jitter at very high data rates.

Therefore, the present inventor
(s) proposes a novel and advanced technology capable of implementing the phase synchronization using a baseband signal in the broadband RF communication and setting a relationship between a carrier frequency and a data rate of the baseband signal in the broadband RF communication.

### SUMMARY

One object of the present disclosure is to solve all the above-described problems.

Another object of the present disclosure is to implement phase synchronization using a baseband signal in a broadband RF communication.

Yet another object of the present disclosure is to minimize influence of a side lobe derived from a negative frequency domain on a communication quality in implementing the broadband RF communication.

Representative configurations of the present disclosure to achieve the above objects are described below.

According to the present invention, there is provided a system for implementing a broadband radio frequency (RF) communication in accordance with appended claim 1.

According to the present invention, there is provided a method for implementing a broadband RF communication in accordance with appended claim 2.

### BRIEF DESCRIPTION OF THE DRAWINGS

FIG. 1 illustratively shows a configuration of a radio frequency (RF) communication system in the related art.
FIG. 2 illustratively shows a configuration of a receiving end of a broadband RF communication system according to one embodiment of the present disclosure.
FIGS. 3 to 6B illustratively show a difference in communication quality in a relationship between a carrier frequency and a data rate according to another embodiment of the present disclosure.
FIGS. 7 and 8 illustratively show an operation in which the receiving end of the broadband RF communication system according to one embodiment of the present disclosure performs a phase synchronization using a baseband signal.
FIG. 9 illustratively shows a result of simulating a phase synchronization process according to one embodiment of the present disclosure.

### DETAILED DISCRIPTION

In the following detailed description of the present disclosure, references are made to the accompanying drawings that show, by way of illustration, specific embodiments in which the present disclosure may be practiced. These embodiments are described in sufficient detail to enable those skilled in the art to practice the present disclosure. It is to be understood that the various embodiments of the present disclosure, although different from each other, are not necessarily mutually exclusive. Therefore, the following detailed description is not to be taken in a limiting sense, and the scope of the present disclosure is to be taken as encompassing the scope of the appended claims. In the drawings, like reference numerals refer to the same or similar functions throughout the several views.

Hereinafter, various preferred embodiments of the present disclosure will be described in detail with reference to the accompanying drawings to enable those skilled in the art to easily implement the present disclosure.

In the present specification, the radio frequency (RF) communication system should be understood as the widest concept encompassing a transceiver provided with a transmitting end for transmitting a RF signal and a receiving end for receiving the RF signal.

### Configuration of Broadband RF Communication System

Next, an internal configuration and each element of a broadband RF communication system which performs major functions to implement the present disclosure will be described.

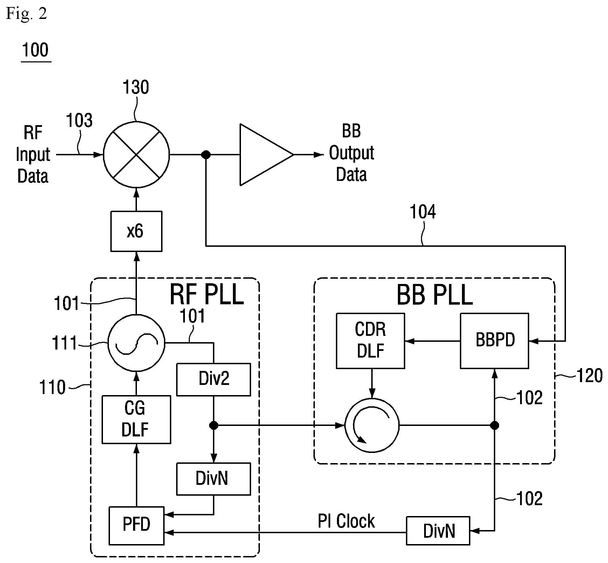

FIG. 2 illustratively shows a configuration of a receiving end of the broadband RF communication system according to an example embodiment of the present disclosure.

Referring to FIG. 2, the receiving end of the broadband RF communication system 100 according to one embodiment of the present disclosure may include a first phase locked loop (PLL) unit 110, a second PLL unit 120, a demodulating unit 130, and a control unit 140.

According to one embodiment of the present disclosure, the first PLL unit100 (i.e., a RF PLL in FIG. 2) may perform a function of generating a first clock 101 based on a reference clock.

According to one embodiment of the present disclosure, the second PLL unit120 (i.e., a baseband (BB) PLL in FIG. 2) may perform a function of generating a second clock 102 based on the first clock 101 generated by the first PLL unit 110 and a baseband signal 104 generated by demodulating a reception signal. That is, according to one embodiment of the present disclosure, a phase of the second clock 102 may be synchronized with a phase of the baseband signal 104.

According to one embodiment of the present disclosure, the demodulating unit 130 may perform a function of generating the baseband signal 104 by demodulating a reception signal 103 (i.e., an RF signal) using a carrier frequency determined by the first clock 101 generated by the first PLL unit 110.

According to one embodiment of the present disclosure, the control unit 140 may perform a function of determining the reference clock to be provided to the first PLL unit 110 in accordance with whether frequency locking in which an initial carrier frequency is substantially the same value as a target carrier frequency is sensed. According to one embodiment of the present disclosure, an initial clock as the reference clock provided to the first PLL unit 110 in order to generate the initial carrier frequency may be set as a predetermined value, which will be described later. For example, the initial clock may be set to "the target carrier frequency/X" (where, X may be an integer and may not be an integer). In this case, the control unit 140 according to one embodiment of the present disclosure may sense that the frequency locking occurs when a difference between a value of "the initial carrier frequency/X" and a value of "the target carrier frequency/X" is smaller than a predetermined level.

Specifically, according to one embodiment of the present disclosure, the first clock 101 generated by the first PLL unit 110 may be provided to the second PLL unit 120 and the demodulating unit 130. The second clock 102 generated by the second PLL unit 120 may be provided to the first PLL unit 110 as the reference clock. The carrier frequency used in demodulating the reception signal 103 may be determined by the first clock 101.

According to one embodiment of the present disclosure, the second PLL unit 120 may be driven using the first clock 101 generated by the first PLL unit 110 and the baseband signal 104 generated by the demodulating unit 130. The first PLL unit 110 may be driven using the second clock 102 generated by the second PLL unit 120. Thus, the phase of the first clock 101 generated by the first PLL unit 110 and the phase of the second clock 102 generated by the second PLL unit 120 may be synchronized with each other. Further, the phase synchronization may be made at the receiving end of the broadband RF communication system. That is, according to one embodiment of the present disclosure, the second clock 102 which is phase-locked to the baseband signal 104 by the second PLL unit 120 may be used as the reference clock for the first PLL unit 110, which makes it possible to implement the RF phase synchronization.

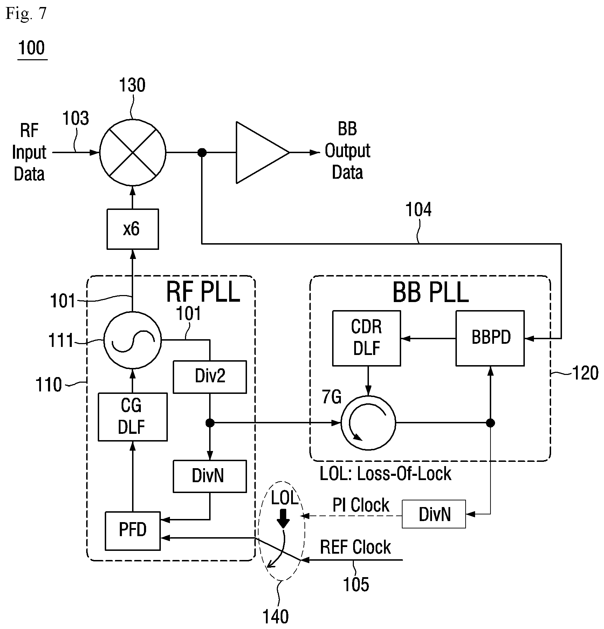

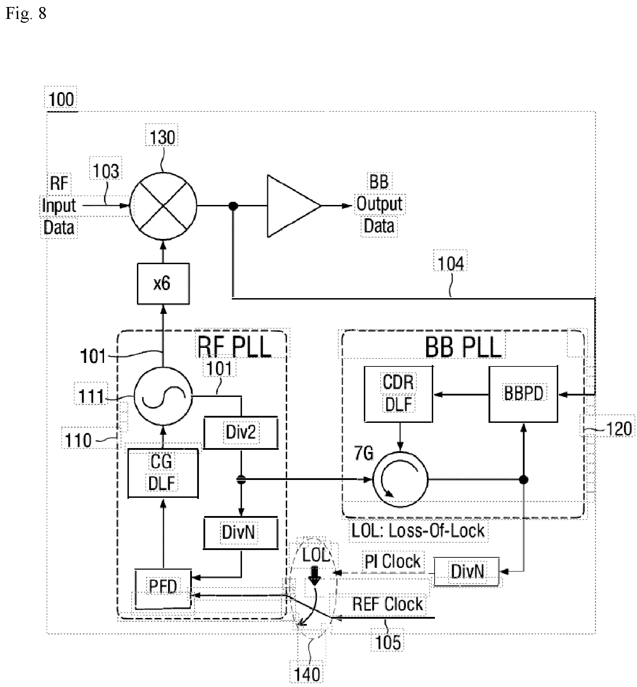

FIGS. 7 and 8 illustratively show an operation in which the receiving end of the broadband RF communication system according to one embodiment of the present disclosure performs the phase synchronization using the baseband signal.

First, referring to FIG. 7, when the first PLL unit 110 is in an initial state, an arbitrary initial clock 105 may be provided to the first PLL unit 110 as a reference clock. As a result, an oscillation part 111 of the first PLL unit 110 may generate the first clock 101 based on the arbitrary initial clock 105. The first clock 101 thus generated may determine the initial carrier frequency (e.g., six times the first clock). Further, the initial carrier frequency determined as above may be closer to the target carrier frequency over time.

Next, as illustrated in FIG. 8, when a frequency locking in which the initial carrier frequency is close to the target carrier frequency by a certain level or more is sensed, the control unit 140 may control a path through which the second clock 102 is provided to the first PLL unit 110 as the reference clock. This makes it possible to synchronize the phase of the first clock 101 generate by the first PLL unit 110 and the phase of the second clock 102 generate by the second PLL unit 120 with each other.

Specifically, referring to FIG. 8, a clock obtained by applying a frequency division on the second clock 102 (i.e., a PI clock in FIG. 8) may be used as the reference clock for the first PLL unit 110. Thus, the oscillation part 111 of the first PLL unit 110 may be phase-locked to the PI clock. As a result, in both the first PLL unit 110 and the second PLL unit 120, the oscillation part 111 of the first PLL unit 110 may be phase-locked to the baseband signal 104. That is, the carrier frequency determined by the first clock 101 is phase-locked to the baseband signal 104, thereby achieving the phase synchronization.

As described above, according to one embodiment of the present disclosure, it is possible to track a dynamic phase offset and achieve the phase synchronization using a baseband PLL (i.e., the second PLL unit 120) without a forwarded clock, an I/Q demodulation or an external control.

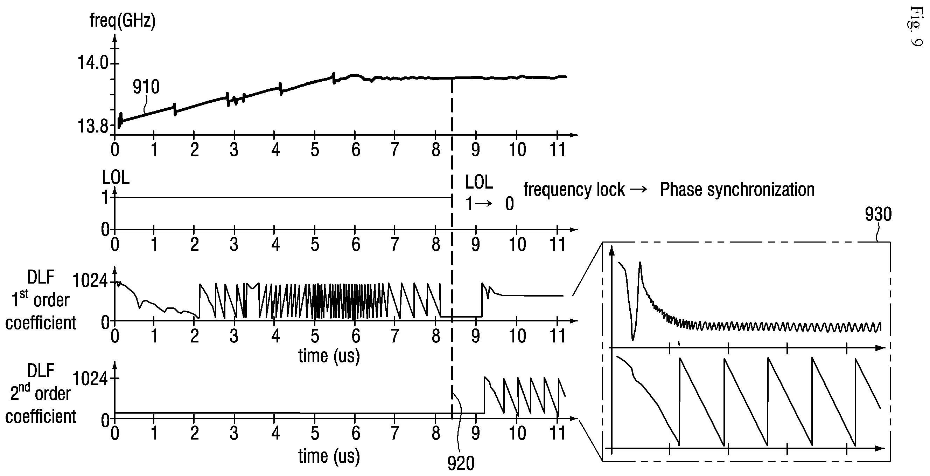

FIG. 9 illustratively shows a result of simulating a phase synchronization process according to one embodiment of the present disclosure.

Referring to FIG. 9, it was found that an initial carrier frequency 910 (of about 13.8 GHz), which is determined by the first clock generated when the arbitrary initial clock is provided to the first PLL unit as the reference clock, becomes close to the target carrier frequency (of 14 GHz) over time.

Further, as illustrated in FIG. 9, it was found that, when a frequency locking in which the initial carrier frequency is close to the target carrier frequency by a predetermined level or more occurs (*see* 920), the second clock is provided as the reference clock to the first PLL unit, which implements the phase synchronization and significantly reduces jitter appearing on the time domain (*see* 930).

### Another Embodiment

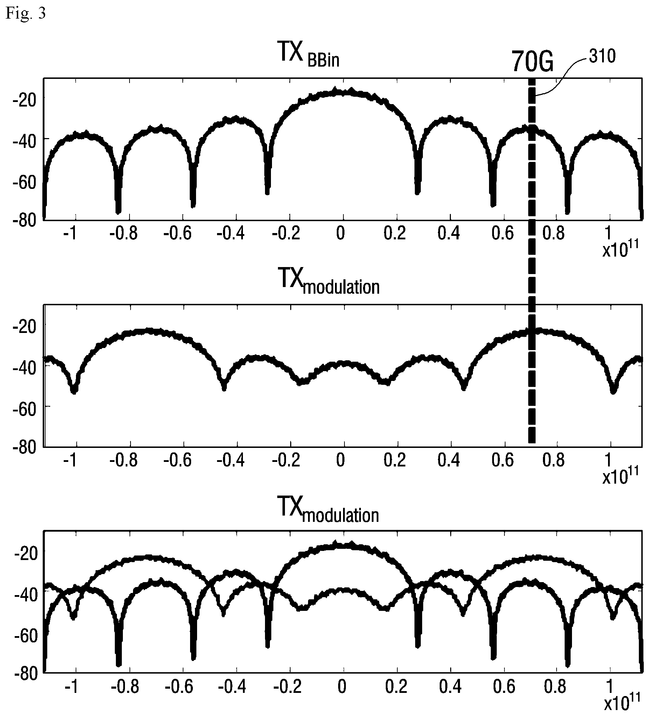

FIGS. 3 to 6B illustratively show a difference in communication quality in a relationship between a carrier frequency and a data rate according to another embodiment of the present disclosure.

Referring to FIG. 3, in a case in which the data rate of the baseband signal is 56 Gbps (corresponding to 28 GHz) and a carrier frequency 310 is set to 70 GHz so that the carrier frequency and the data rate do not satisfy a predetermined relationship (e.g., an integer multiple relationship or the like), a side lobe derived from a negative frequency domain is affected, resulting in a significantly reduced signal null depth.

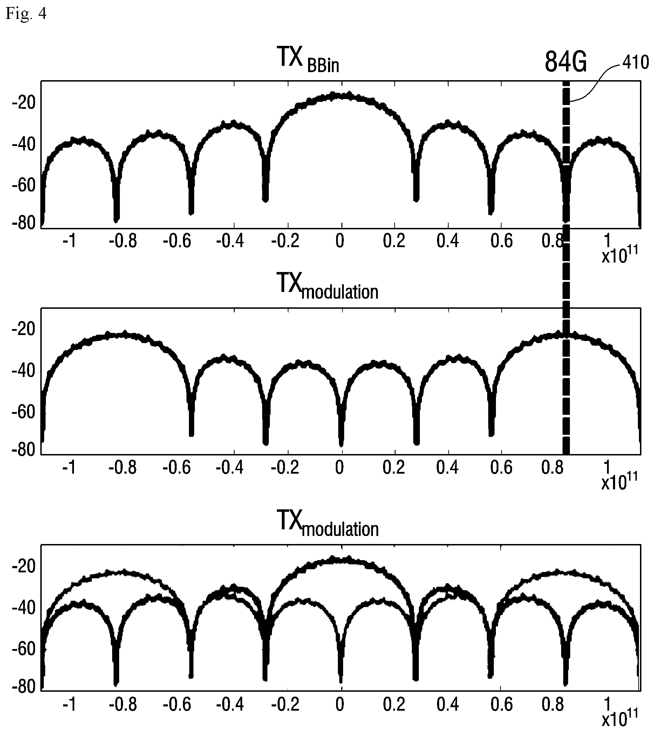

Referring to FIG. 4, in a case in which the data rate of the baseband signal is 56 Gbps (corresponding to 28 GHz) and a carrier frequency 410 is set to 84 GHz so that the carrier frequency and the data rate satisfy the predetermined relationship (i.e., carrier frequency/data rate=3), the side lobe derived from the negative frequency domain do not significantly affect the signal null depth.

Such a problem in which the signal null depth is reduced due to the fact that the carrier frequency and the data rate do not satisfy the predetermined relationship as described above, may similarly appear even in the baseband signal.

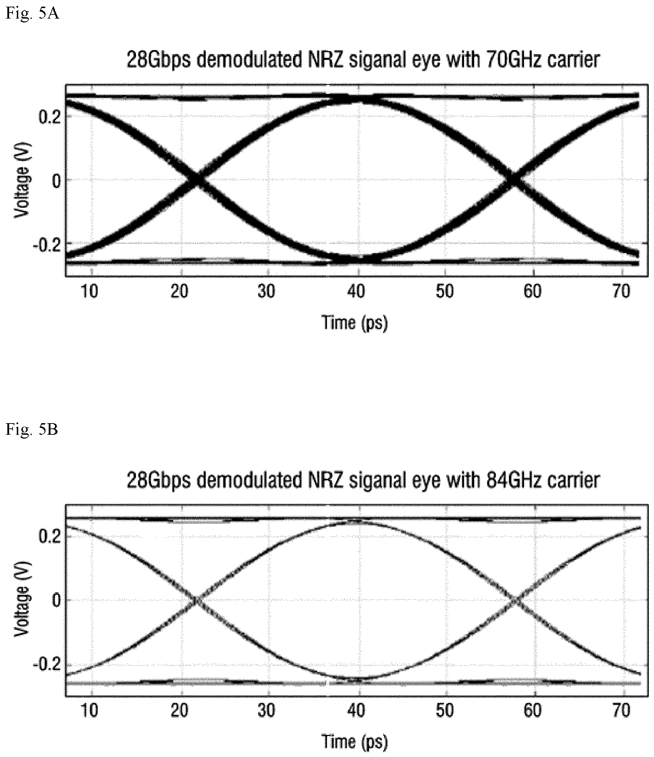

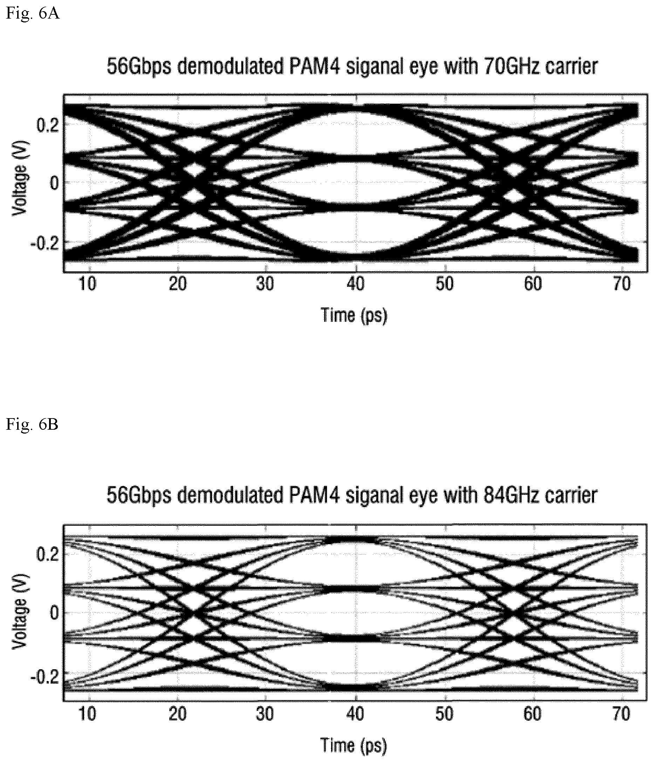

The following results can be found referring to FIGS. 5A to 6B. As a result of comparing eye diagrams (FIGS. 5A and 5B, and FIG. 6B) in the case in which the carrier frequency and the data rate satisfy the predetermined relationship with eye diagrams (FIGS. 5A and 5B, and FIG. 6A) in the case in which the carrier frequency and the data rate do not satisfy the predetermined relationship, the former causes the signal null depth having a smaller loss than that in the latter, and thus a deterministic jitter also appears at a relatively small level on the time domain.

Based on the above, in a broadband RF communication system (not shown) according to another embodiment of the present disclosure, a carrier frequency may be set to have a predetermined relationship with a data rate of a baseband signal in order to increase communication quality. For example, the carrier frequency may be set to a value that is an integer multiple of the data rate.

Specifically, according to another embodiment of the present disclosure, a control unit (not shown) of the broadband RF communication system may perform a function of controlling a frequency of a clock (i.e., a clock generated by a PLL in a receiving end) to be used as a basis of the carrier frequency to have a predetermined value so that the carrier frequency and the data rate of the baseband signal satisfy the predetermined relationship.

For example, it is assumed that a case in which the data rate of the baseband signal is 56 Gbps (corresponding to 28 GHz), and the carrier frequency needs to be set to 84 GHz in order to satisfy the predetermined relationship with the data rate (i.e., the ratio of the carrier frequency to the data rate is 3). In this case, the control unit according to another embodiment of the present disclosure may control the frequency of the clock generated by the PLL at the receiving end to be 14 GHz. Thus, by multiplying the clock thus generated by a factor of 6, it is possible to generate the carrier frequency of 84 GHz.

Further, according to another embodiment of the present disclosure, a demodulating unit (not shown) of the broadband RF communication system may perform a function of generating the baseband signal by demodulating a reception signal (i.e., a broadband RF signal) using the carrier frequency generated to have the predetermined relationship with the data rate of the baseband signal as described above.

In the above-described another embodiment, the carrier frequency has been mainly described to have the integer multiple of the data rate of the baseband signal. However, the present disclosure is not necessarily limited to the above, and the relationship between the carrier frequency and the data rate of the baseband signal may be set in various forms. The relationship may be changed as long as the object of the present disclosure of reducing the influence of the side lobe derived from the negative frequency domain may be achieved.

In the above-described another embodiment, the configuration in which the carrier frequency and the data rate of the baseband signal have the predetermined relationship with each other may not be necessarily applied to the phase synchronization system and the method therefor according to one embodiment of the present disclosure. That is, the phase synchronization system and the method therefor according to one embodiment of the present disclosure may implement the phase synchronization without additionally setting the relationship between the carrier frequency and the data rate of the baseband signal.

While in the above, the details or parameters of the constituent elements included in the broadband RF communication system according to the present disclosure have been described in detail, the configuration of the broadband RF communication system according to the present disclosure is not necessarily limited to the above, and may be changed without limitation as long as the aspects and effects of the present disclosure may be achieved.

Although the present disclosure has been described above in terms of specific items such as detailed elements as well as the limited embodiments and the drawings, they are merely provided to help more general understanding of the present disclosure, and the present disclosure is not limited to the above embodiments. It will be appreciated by those skilled in the art to which the present disclosure pertains that various modifications and changes may be made from the above description.

Therefore, the present disclosure shall not be limited to the above-described embodiments, but to the scope of the appended claims.

## Claims

1. A system (100) for implementing a broadband radio frequency, RF, communication, the system (100) comprising:
a first phase locked loop, PLL, unit (110) configured to generate a first clock (101) based on a reference clock; and
a second PLL unit (120) configured to generate a second clock (102) based on the first clock (101) generated by the first PLL unit (110) and a baseband signal (104) generated by demodulating a reception signal,
wherein a carrier frequency used for demodulating the reception signal (103) is determined by the first clock (101),
**characterized in that** the system (100) is configured such that, when the first PLL unit (110) is in an initial state, the first clock (101) that determines an initial carrier frequency is generated using an arbitrary initial clock (105) as the reference clock, and such that when a frequency locking in which the initial carrier frequency approaches a target carrier frequency by a predetermined level or more is detected, the second clock (102) is provided to the first PLL as the reference clock, and
wherein a phase synchronization is implemented as the phase of the first clock (101) is synchronized with the phase of the baseband signal (104).

2. A method for implementing a broadband RF communication, the method comprising:
a step in which a first phase locked loop, PLL, unit (110) generates a first clock (101) based on a reference clock; and
a step in which a second PLL unit generates a second clock based on the first clock (101) generated by the first PLL unit (110) and a basedband signal (104) generated by demodulating a reception signal,
wherein a carrier frequency used for demodulating the reception signal (103) is determined by the first clock (101),
**characterized in that** the system is configured such that, when the first PLL unit (110) is in an initial state, the first clock (101) is generated using an arbitrary initial clock (105) as the reference clock, and such that when a frequency locking in which the initial carrier frequency approaches a target carrier frequency by a predetermined level or more is detected, the second clock (102) is provided to the first PLL as the reference clock, and
wherein a phase synchronization is implemented as the phase of the first clock is (101) synchronized with the phase of the baseband signal (104).

## Patentansprüche

1. System (100) zum Implementieren einer Breitband-Hochfrequenzkommunikation (RF), wobei das System (100) Folgendes umfasst:
eine erste Phasenregelkreis (PLL) -Einheit (110), die so konfiguriert ist, dass sie einen ersten Takt (101) auf der Grundlage eines Referenztakts erzeugt; und
eine zweite PLL-Einheit (120), die so konfiguriert ist, dass sie einen zweiten Takt (102) auf der Grundlage des von der ersten PLL-Einheit (110) erzeugten ersten Takts (101) und eines durch Demodulieren eines Empfangssignals erzeugten Basisbandsignals (104) erzeugt,
wobei eine zum Demodulieren des Empfangssignals (103) verwendete Trägerfrequenz durch den ersten Takt (101) bestimmt wird,
**dadurch gekennzeichnet, dass** das System (100) so konfiguriert ist, dass, wenn sich die erste PLL-Einheit (110) in einem Anfangszustand befindet, der erste Takt (101), der eine Anfangsträgerfrequenz bestimmt, unter Verwendung eines beliebigen Anfangstakts (105) als Referenztakt erzeugt wird, und dass, wenn eine Frequenzverriegelung erkannt wird, bei der sich die Anfangsträgerfrequenz einer Ziel-Trägerfrequenz um einen vorbestimmten Wert oder mehr annähert, der zweite Takt (102) der ersten PLL als Referenztakt bereitgestellt wird, und
wobei eine Phasensynchronisation implementiert wird, indem die Phase des ersten Takts (101) mit der Phase des Basisbandsignals (104) synchronisiert wird.

2. Verfahren zum Implementieren einer Breitband-Hochfrequenzkommunikation (RF), wobei das Verfahren Folgendes umfasst:
einen Schritt, in dem eine erste Phasenregelkreis (PLL) -Einheit (110) einen ersten Takt (101) auf der Grundlage eines Referenztakts erzeugt; und
einen Schritt, in dem eine zweite PLL-Einheit einen zweiten Takt auf der Grundlage des von der ersten PLL-Einheit (110) erzeugten ersten Takts (101) und eines durch Demodulieren eines Empfangssignals erzeugten Basisbandsignals (104) erzeugt,
wobei eine zum Demodulieren des Empfangssignals (103) verwendete Trägerfrequenz durch den ersten Takt (101) bestimmt wird,
**dadurch gekennzeichnet, dass** das System so konfiguriert ist, dass, wenn sich die erste PLL-Einheit (110) in einem Anfangszustand befindet, der erste Takt (101) unter Verwendung eines beliebigen Anfangstakts (105) als Referenztakt erzeugt wird, und dass, wenn eine Frequenzverriegelung, bei der sich die Anfangsträgerfrequenz einer Ziel-Trägerfrequenz um einen vorbestimmten Wert oder mehr annähert, erkannt wird, der zweite Takt (102) der ersten PLL als Referenztakt bereitgestellt wird, und
wobei eine Phasensynchronisation implementiert wird, indem die Phase des ersten Takts (101) mit der Phase des Basisbandsignals (104) synchronisiert wird.

## Revendications

1. Un système (100) pour mettre en œuvre une communication radiofréquence, RF, à large bande, le système (100) comprenant :
une première unité à boucle à verrouillage de phase, PLL, (110) configurée pour générer une première horloge (101) sur la base d'une horloge de référence ; et
une deuxième unité PLL (120) configurée pour générer une deuxième horloge (102) sur la base de la première horloge (101) générée par la première unité PLL (110) et d'un signal en bande de base (104) généré par démodulation d'un signal de réception,
dans lequel une fréquence porteuse utilisée pour démoduler le signal de réception (103) est déterminée par la première horloge (101),
**caractérisé en ce que** le système (100) est configuré de telle sorte que, lorsque la première unité PLL (110) est dans un état initial, la première horloge (101) qui détermine une fréquence porteuse initiale est générée en utilisant une horloge initiale arbitraire (105) comme horloge de référence, et de telle sorte que, lorsqu'un verrouillage de fréquence dans lequel la fréquence porteuse initiale s'approche d'une fréquence porteuse cible d'un niveau prédéterminé ou plus est détecté, la deuxième horloge (102) est fournie à la première PLL comme horloge de référence, et
dans lequel une synchronisation de phase est mise en œuvre lorsque la phase de la première horloge (101) est synchronisée avec la phase du signal en bande de base (104).

2. Procédé pour mettre en œuvre une communication RF à large bande, le procédé comprenant :
une étape dans laquelle une première unité à boucle à verrouillage de phase, PLL, (110) génère une première horloge (101) sur la base d'une horloge de référence ; et
une étape dans laquelle une deuxième unité PLL génère une deuxième horloge sur la base de la première horloge (101) générée par la première unité PLL (110) et d'un signal en bande de base (104) généré par démodulation d'un signal de réception,
dans lequel une fréquence porteuse utilisée pour démoduler le signal de réception (103) est déterminée par la première horloge (101),
**caractérisé en ce que** le système est configuré de telle sorte que, lorsque la première unité PLL (110) est dans un état initial, la première horloge (101) est générée en utilisant une horloge initiale arbitraire (105) comme horloge de référence, et de telle sorte que, lorsqu'un verrouillage de fréquence dans lequel la fréquence porteuse initiale s'approche d'une fréquence porteuse cible d'un niveau prédéterminé ou plus est détecté, la deuxième horloge (102) est fournie à la première PLL comme horloge de référence, et
dans lequel une synchronisation de phase est mise en œuvre lorsque la phase de la première horloge (101) est synchronisée avec la phase du signal en bande de base (104).
